# EUROPEAN PATENT APPLICATION

(11) **EP 1 722 619 A1**
(43) Date of publication of application: **15.11.2006**
(21) Application number: 05726575.3
(22) Date of filing: 28.02.2005
(51) Int. Cl.: H05K 9/00, G09F 9/00, H01J 11/02

(54) **ELECTROMAGNETIC SHIELDING LIGHT TRANSMITTING WINDOW MATERIAL, DISPLAY PANEL AND METHOD FOR MANUFACTURING SOLAR CELL MODULE**

(30) Priority: 03.03.2004 JP 2004059328; 03.03.2004 JP 2004059329
(71) Applicant: Bridgestone Corporation, Tokyo 104-8340 (JP)
(72) Inventor: YOSHIKAWA, Masato, c/o Tech. Ctr. Bridgestone Corp, Kodaira-shi, Tokyo 1870031 (JP)
(74) Representative: Whalley, Kevin
(86) International application number: PCT/JP2005/003309
(87) International publication number: WO 2005/086557

(57) **Abstract**

In order to decrease the time (adhesion time in an adhesion step) for manufacturing an electromagnetic-wave shielding and light transmitting window material and a display panel, a top mold 43 and a bottom mold 44, which are made of a synthetic resin having high heat resistance, are disposed between a top and a bottom pressing plate 41 and 42, and a laminate is disposed between the molds 43 and 44. This laminate is formed of a transparent substrate 32A provided with an anti-reflection film 35, an adhesive interlayer film 34A used as an adhesive resin, an electrical conductive mesh 33, an adhesive interlayer film 34B, and a transparent substrate 32B provided with a black frame paint 36. While air in a molding space between the molds 43 and 44 is vacuum-evacuated via an exhaust port 45, a high-frequency voltage is simultaneously applied to the pressing plates 41 and 42 from a high-frequency power source 46, and in addition, the above laminate is pressed by the pressing plats 41 and 42 for a predetermined time. Accordingly, the interlayer films 34A and 34B is heated by induction heating and is cured, and as a result, the laminate is integrated.

## Description

### Field of the Invention

The present invention relates to a manufacturing method of an electromagnetic-wave shielding and light transmitting window material which is effectively used, for example, for a front filter of PDP (plasma display panel). The present invention relates to a manufacturing method of a display panel for a plasma display panel or the like.

The present invention relates to a method for manufacturing a solar battery module by sealing solar battery cells between a front-surface side protective member and a rear-surface side protective member.

### Background Art

I. In recent years, concomitant with increase in demand of OA devices, communication devices, and the like, electromagnetic waves generated therefrom has begun to be considered as a problem. That is, influence of electromagnetic waves on human bodies is of concern, and in addition, malfunctions of precision apparatuses caused by electromagnetic waves have become problems.

Accordingly, as front filters of PDP of OA devices, a window material having electromagnetic-wave shielding properties and light transmission properties was developed and has been practically used. In order to protect precision apparatuses from electromagnetic waves emitted from mobile phones and the like, the window materials as described above are also used as a window material for places in hospitals, laboratories, and the like at which precision apparatuses are installed.

In Japanese Unexamined Patent Application Publication No. 11-84081, as an electromagnetic-wave shielding and light transmitting window material which is easily assembled in a housing and which can be uniformly electrically connected thereto with a low connection resistance, a window material has been disclosed which is formed by the steps of disposing an electrical conductive mesh between two transparent substrates so that a peripheral portion of the electrical conductive mesh extends past peripheral portions of the substrates, folding the extending peripheral portion along the peripheral portion of the transparent substrate, and fixing the folded extending peripheral portion to the transparent substrate with an electrical conductive adhesive tape.

As described above, when the peripheral portion of the electrical conductive mesh extending past the transparent substrates is fixed thereto with the electrical conductive adhesive tape, the mesh is prevented from loosening, and in addition, the peripheral portion thereof can be stably fixed. Hence, the electromagnetic-wave shielding and light transmitting window material can be easily assembled in a housing, and in addition, superior electrical conduction can be obtained between the housing and the electrical conductive mesh of the electromagnetic-wave shielding and light transmitting window material via the electrical conductive adhesive tape.

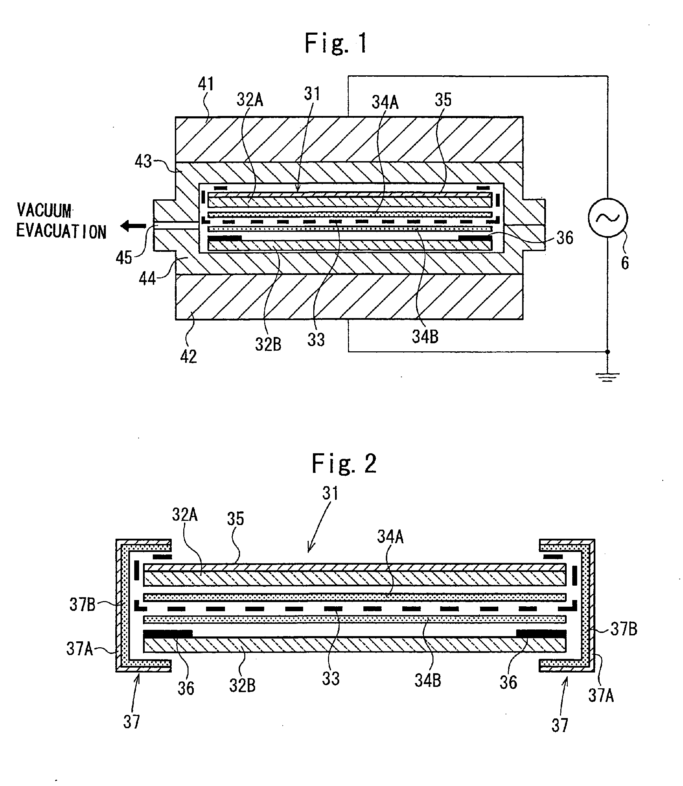

Fig. 2 is a schematic cross-sectional view showing an embodiment of the electromagnetic-wave shielding and light transmitting window material described in the above Japanese Unexamined Patent Application Publication.

An electromagnetic-wave shielding and light transmitting window material 31 has the following structure. That is, two transparent substrates 32A and 32B are integrally adhered to each other with an electrical conductive mesh 33 provided therebetween, the electrical conductive mesh 33 being sandwiched with adhesive interlayer films 34A and 34B, and the peripheral of the electrical conductive mesh 33 extending past peripheral portions of the transparent substrates 32A and 32B is folded along the periphery of the transparent substrate 32A and is adhered to the transparent substrate with an electrical conductive adhesive tape 37.

The electrical conductive adhesive tape 37 is adhered to the end surface all along the laminate made of the transparent substrates 32A and 32B with the electrical conductive mesh 33 provided therebetween, is folded along front and rear peripheral corners of the laminate, and is then adhered to a peripheral portion of a plate surface of one transparent substrate 32A and to a peripheral portion of a plate surface of the other transparent substrate 32B.

The electrical conductive adhesive tape 37 is formed, for example, of a metal foil 37A and an electrical conductive adhesive layer 37B provided on one surface thereof. As the metal foil 37A of the electrical conductive adhesive tape 37, a foil of copper, silver, nickel, aluminum, stainless steel or the like having a thickness of approximately 1 to 100 µm may be used.

In addition, the electrical conductive adhesive layer 37B is formed by applying an adhesive containing electrical conductive particles dispersed therein to one surface of the metal foil 37A as described above.

On the peripheral portion of the transparent substrate 32B which is located at the rear surface side, a black frame paint 36 primary formed of an acrylic resin is provided. In addition, on the surface of the transparent substrate 32A which is located at the front surface side, an anti-reflection film 35 is formed.

II. In Japanese Unexamined Patent Application Publication No. 2002-341781, the following display panel has been disclosed as a display panel using an electromagnetic-wave shielding film which has high anti-reflection effect, high transparency, and superior visibility besides superior electromagnetic-wave shielding properties. That is, the display panel thus disclosed has a display panel main body and an electromagnetic-wave shielding film disposed on the front surface of the display panel main body, and the electromagnetic-wave shielding film has a transparent base film and a pattern-etched electrical conductive foil which is adhered to the base film with a transparent adhesive interposed therebetween.

This display panel is a display panel having a display panel main body and an electromagnetic-wave shielding film disposed on the front surface thereof, and by reduction in weight, thickness, and number of parts of the display panel, improvement in productivity and reduction in cost can be achieved.

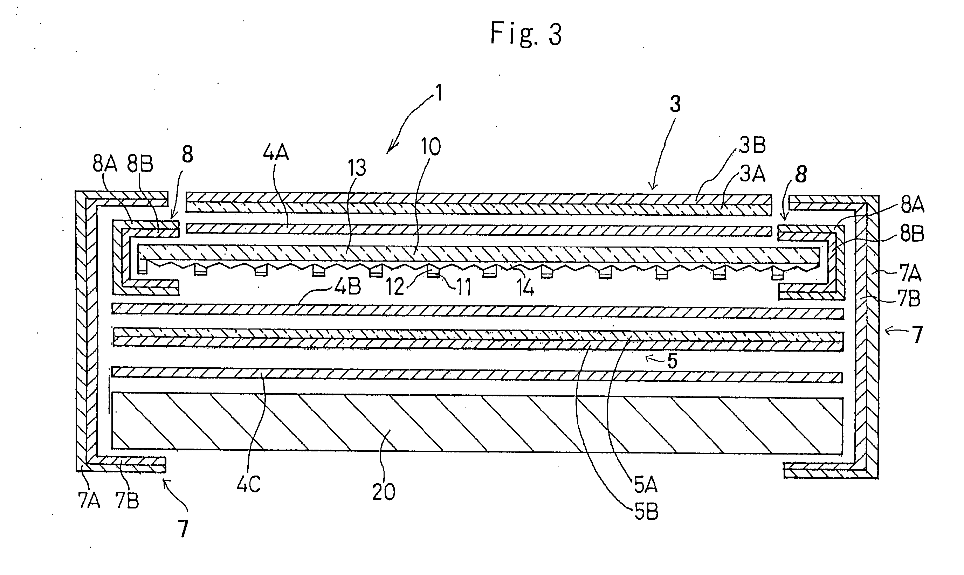

Fig. 3 is a schematic cross-sectional view showing the display panel disclosed in the above Japanese Unexamined Patent Application Publication No. 2002-341781.

A display panel 1 shown in Fig. 3 is formed by the following procedure. That is, a topmost anti-reflection film 3, a copper/PET laminate etched film 10 as an electromagnetic-wave shielding film, a near infrared cut film 5, and a PDP main body 20 are integrally laminated to each other to forma a laminate with adhesive interlayer films 4A, 4B, and 4C used as an adhesive, and an electrical conductive adhesive tape 7 (hereinafter referred to as a "second electrical conductive adhesive tape") is adhered to the end surface of this laminate and to top and bottom peripheral portions which are close to the end surface, so that an integrated laminate is formed.

The electromagnetic-wave shielding film 10 has a size approximately equivalent to that of the PDP main body 20, and an electrical conductive adhesive tape 8 (hereinafter referred to as a "first electrical conductive adhesive tape") is adhered to the peripheral portion of the electromagnetic-wave shielding film 10 from one side surface to the other side surface thereof via its end surface. This first electrical conductive adhesive tape 8 is preferably provided all along the peripheral portion of the electromagnetic-wave shielding film 10; however, for example, it may be provided for two peripheral side portions facing to each other.

In this display panel 1, the anti-reflection film 3 and the adhesive interlayer film 4A located thereunder are slightly smaller than the electromagnetic-wave shielding film 10, and the periphery of the anti-reflection film 3 and that of the adhesive interlayer film 4A are located slightly inside (such as 3 to 20 mm, and in particular, approximately 5 to 10 mm is preferable) from the peripheral portion of the electromagnetic-wave shielding film 10, and hence the first electrical conductive adhesive tape 8 provided at the peripheral portion of the electromagnetic-wave shielding film 10 is not covered with the anti-reflection film 3 and the adhesive interlayer film 4A. Accordingly, the second electrical conductive adhesive tape 7 is directly provided on the first electrical conductive adhesive tape 8, and the electromagnetic-wave shielding film 10 is reliably electrically connected via the first and the second electrical conductive adhesive tapes 8 and 7.

Since it is necessary to electrically connect between the first electrical conductive adhesive tape 8 and the second electrical conductive adhesive tape 7, the anti-reflection film 3 and the adhesive interlayer film 4A are formed smaller than the electromagnetic-wave shielding film 10, and the peripheries of the above films are located inside from the periphery of the electromagnetic-wave shielding 10.

As a thermosetting resin forming the adhesive interlayer films 4A, 4B, and 4C which adhere the anti-reflection film 3, the electromagnetic-wave shielding films 10 and 10a, the near infrared cut film 5, and the PDP main body 20 to each other, a transparent elastic film having high scattering prevention properties, such as a film generally used as an adhesive for glass laminates, is preferably used, and in general, an EVA resin film is used.

When an adhesive interlayer film made of a cross-linking EVA resin film is used, in laminating and adhering constituent members of the panels 1 and 1a to each other, the constituent members are laminated to each other with the adhesive interlayer films 4A to 4C interposed therebetween, followed by temporary pressure bonding (after this temporary pressure bonding, the above adhesion may again be performed when it is necessary), and subsequently, pressure application and heating are performed, so that the constitution members can be adhered to each other without remaining bubbles therebetween. Accordingly, in the display panel 1 shown in Fig. 3, after the electromagnetic-wave shielding film 10 and the near-infrared light cut filter 5 are laminated with the adhesive interlayer film 4B interposed therebetween, and temporary pressure bonding is the performed, by performing pressure application and heating, the electromagnetic-wave shielding film 10 and the near-infrared light cut filter 5 can be adhered to each other without remaining bubbles therebetween. Hence, an adhesive resin 4B' of the adhesive interlayer film 4B is applied so as to totally fill fine irregularities of a surface 14A of a transparent adhesive 14 of the electromagnetic-wave shielding film 10, and as a result, light scattering caused by the above irregularities can be reliably prevented.

In the adhesion step using the adhesive interlayer films 4A, 4B, 4C, 34A and 34B, heating is performed using a constant-temperature bath maintained at a predetermined temperature; however, it takes time to increase the temperature of the adhesive interlayer films.

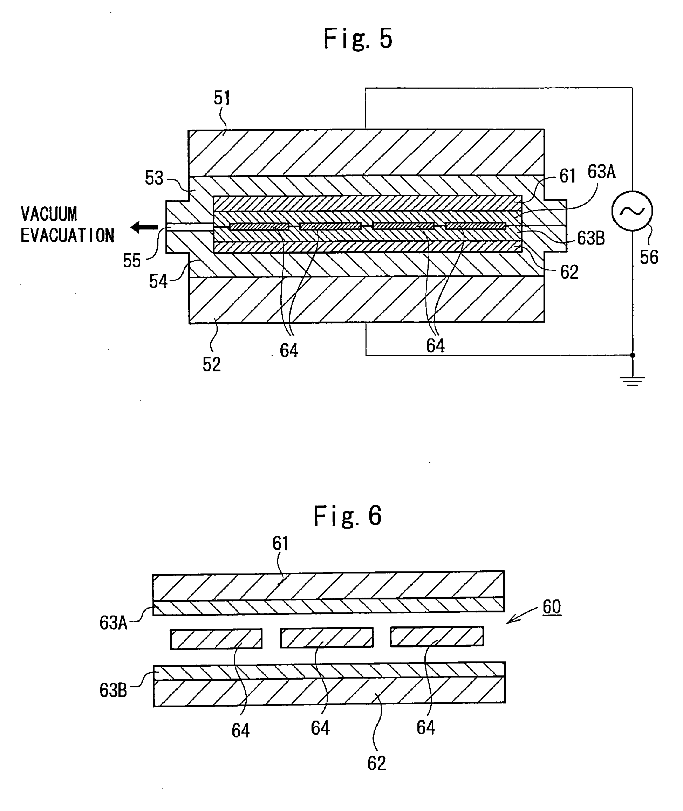

III. In general, as shown in Fig. 6, a solar battery has the structure in which solar battery cells 64 are sealed with sealing films 63A and 63B which are made of an ethylene-vinyl acetate copolymer (EVA) resin film and which are provided between a rear surface-side transparent protective member (back cover member) 62 and a front surface-side transparent protective member 61 which is located at a light-receiving surface side.

A solar battery module 60 as described above is integrally formed (for example, as disclosed in Japanese Unexamined Patent Application Publication No. 2002-185026) by adhesion using the steps of laminating the front surface-side transparent protective member 61 such as a glass substrate, the sealing film 63A, the cells 64, the sealing film 63B, and the back cover member 62 in that order, and heating and melting the sealing films made of EVA to be cured by cross-linking.

Heretofore, the step of heating the laminate, which is performed when the solar battery cells are sealed, has been performed using a constant-temperature bath maintained at a predetermined temperature; however, it takes time to increase the temperature of the laminate.

### Summary of the Invention

An object of the present invention is to provide methods for manufacturing an electromagnetic-wave shielding and light transmitting window material and a display panel, in which the adhesion can be rapidly performed as compared to that performed in the past.

In accordance with a first aspect of the present invention, there is provided a method for manufacturing an electromagnetic-wave shielding and light transmitting window material in which a transparent base material and an electrical conductive layer adhered to each other with an adhesive resin interposed therebetween, the method comprising the step of heating a laminate of the transparent base material, the electrical conductive layer, and the adhesive resin for adhesion, wherein the heating is performed by induction heating.

In accordance with a second aspect of the present invention, there is provided a method for manufacturing a display panel which has a display panel main body and an electromagnetic-wave shielding film adhered to a front surface of the display panel main body with an adhesive resin interposed therebetween, the method comprising the step of heating a laminate of the display panel main body and the electromagnetic-wave shielding film for adhesion, wherein the heating is performed by induction heating.

When the induction heating is performed in the step of heating the adhesive resin for adhesion, the adhesive resin can be heated in a short period of time as compared to that in the past, and as a result, the manufacturing efficiency of the electromagnetic-wave shielding and light transmitting window material and the display panel can be improved.

An object of the present invention is to provide a method for manufacturing a solar battery module in which heating of a laminate can be rapidly performed in a cell sealing step as compared to that in the past.

In accordance with a third aspect of the present invention, there is provided a method for manufacturing a solar battery module in which solar battery cells are sealed between a front surface side protective member and a rear surface side protective member, the method comprising the steps of: disposing the solar battery cells between the front surface side protective member and the rear surface side protective member with sealing films which are interposed therebetween and which are made of an adhesive resin so as to form a laminate; and heating this laminate under reduced pressure or increased pressure, wherein induction heating is performed in the heating step.

Since the heating step for sealing the solar battery cells is performed by the induction heating, the laminate can be heated within a short period of time as compared to that in the past, and as a result, the manufacturing efficiency of the solar battery module can be improved.

### Brief Description of the Drawings

[Fig. 1] Fig. 1 is a cross-sectional view for illustrating one example of a method for manufacturing an electromagnetic-wave shielding and light transmitting window material according to the present invention.
[Fig. 2] Fig. 2 is a schematic cross-sectional view showing one example of a conventional electromagnetic-wave shielding and light transmitting window material.
[Fig. 3] Fig. 3 is a schematic cross-sectional view showing one example of a conventional display panel.
[Fig. 4] Fig. 4 includes cross-sectional views showing a method for manufacturing an electromagnetic-wave shielding film used in the display panel shown in Fig. 3.
[Fig. 5] Fig. 5 is a cross-sectional view showing a method for manufacturing a solar battery module of one embodiment according to the present invention.
[Fig. 6] Fig. 6 is a cross-sectional view showing a conventional method for manufacturing a solar battery module.

### Preferred Embodiments of the Invention

Hereinafter, with reference to figures, an embodiment of a manufacturing method of an electromagnetic-wave shielding and light transmitting window material according to the first aspect will be described in detail.

Fig. 1 is a schematic cross-sectional view of an adhesion step of the electromagnetic-wave shielding and light transmitting window material according to the first aspect.

In this adhesion step, induction heating is used as heating means.

Between top and bottom pressing plates 41 and 42 made of an electrical conductive material such as a metal, a top mold 43 and a bottom mold 44, which are formed of a high heat resistant synthetic resin, are disposed, and between the molds 43 and 44, a laminate is disposed having the structure shown in Fig. 2 except for the electrical conductive adhesive tape 37.

This laminate is formed of the transparent substrate 32A provided with the anti-reflection film 35, the adhesive interlayer film 34A used as an adhesive resin, the electrical conductive mesh 33, the adhesive interlayer film 34B, and the transparent substrate 32B provided with the black frame paint 36, which were described with reference to Fig. 2.

While air in the molding space between the molds 43 and 44 is evacuated via an exhaust port 45, a high-frequency voltage is simultaneously applied to the pressing plates 41 and 42 from a high-frequency power source 46, and the above laminate is pressed with the pressing plates 41 and 42 for a predetermined time. As a result, the interlayer films 34A and 34b are heated and cured by the inductive heating, so that the laminate is integrated.

Subsequently, after the application of the high-frequency voltage is stopped, and the pressing plates 41 and 42 and the molds 43 and 44 are respectively separated, the laminate is recovered from the molds. Then, the electrical conductive adhesive tape 37 is adhered to the peripheral portion as shown in the figure, so that the electromagnetic-wave shielding and light transmitting window material 31 is manufactured.

By the high-frequency induction heating, since the interlayer films 34A and 34B are rapidly heated, the cycle time of this adhesion step can be decreased as compared to that in the past, and as a result, the manufacturing efficiency can be improved.

Although the high-frequency heating is performed as described with reference to Fig. 1, microwave heating may also be used. In general, high-frequency heating and microwave heating are performed in the range of 1 MHz to 100 MHz and 300 MHz to 300 GHz, respectively; however, in the present invention, high-frequency heating or microwave heating at a frequency of approximately 3 KHz to 30 GHz is preferably performed. By heating of the laminate using a conventional temperature-constant bath, the cycle time will be required to be approximately 20 seconds to 60 minutes; however, according to the present invention, the adhesion can be satisfactorily performed in a shorter period time than that mentioned above.

In Fig. 1, the heating is performed only by induction heating; however, by providing heat sources such as an electrical heater for the pressing plates 41 and 42, the heating of the laminate may be assisted by heat transfer from the pressing plates 41 and 42. That is, the induction heating and the heat-transfer heating may both be used. When the heating is performed as described above, the cycle time of the adhesion step can be further decreased, and in addition, the entire interlayer films 34A and 34B can be more uniformly heated.

In Fig. 1, the pressing plates 41 and 42 are used as electrodes for the induction heating; however, the electrodes may be provided on surfaces of the pressing plates facing to each other. The electrical conductive mesh 33 may be used as an electrode for induction heating.

Fig. 1 relates to a manufacturing method of the electromagnetic-wave shielding and light transmitting window material 31 shown in Fig. 2. A method similar to that may also be applied to a manufacturing method of the display panel 1 shown in Fig. 3.

When the display panel 1 is manufactured, a laminate having the structure shown in Fig. 3 except for the electrical conductive adhesive tape 7, that is, the laminate formed of the anti-reflection film 3, the adhesive interlayer film 4A, the electromagnetic-wave shielding film 10, the adhesive interlayer film 4B, the near infrared cut film 5, the adhesive interlayer film 4C, and the PDP main body 20 is disposed between the pressing plates 41 and 42 shown in Fig. 1, followed by induction heating and pressing.

By this induction heating, the individual adhesive interlayer films 4A, 4B, and 4C are rapidly heated, and as a result, the adhesion step can be performed in a short period of time.

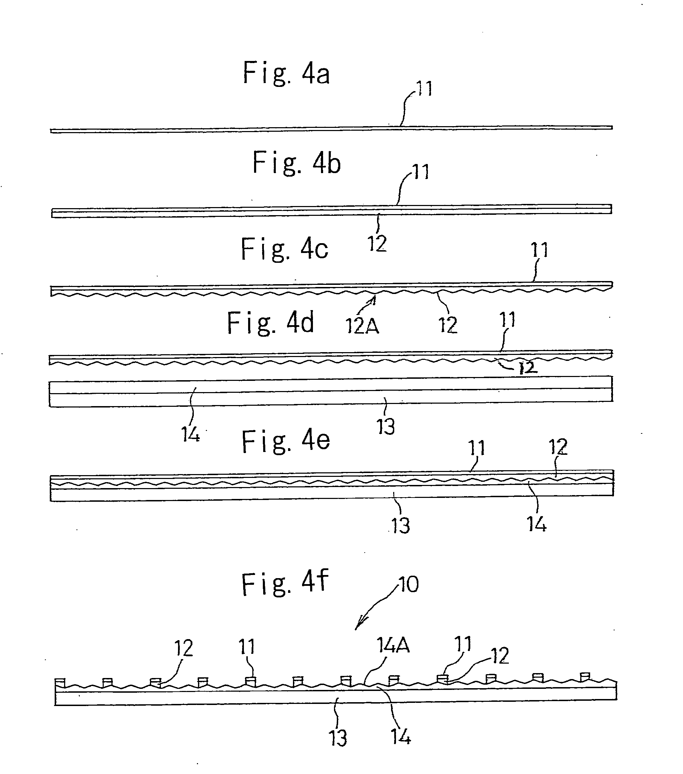

A method for manufacturing the electromagnetic-wave shielding film 10 shown in Fig. 3 will be described with reference to Fig. 4.

As an electrical conductive foil, for example, a copper foil 11 is prepared (Fig. 4a). On one surface of this copper foil 11, a light-absorbing layer 12 is formed (Fig. 4b). This light-absorbing layer 12 can be formed by applying a light-absorbing ink to the copper foil 11, followed by curing. As this light-absorbing ink, for example, a carbon ink, a nickel ink, or an ink made of a dark color-based organic pigment may be used. As a method for forming this light-absorbing layer 12, a method may be mentioned having the steps of forming a copper alloy film made of Cu-Ni or the like, and then blackening it by treatment using an acid, an alkali, or the like. A blackened surface processed by this surface treatment is a roughened surface, and the surface roughness Rz can be changed by its treatment condition. In addition, the light-absorbing layer can be formed by applying a light-absorbing ink on the copper foil 11, followed by curing, and as the light-absorbing ink used in this case, for example, a carbon ink, a nickel ink, or an ink made of a dark color-based organic pigment may be used. Subsequently, a mat treatment is performed for this light-absorbing layer 12 for roughening the surface 12A thereof to form fine irregularities thereon using, for example, a method, such as shot blast, for mechanically roughening a surface, a method for roughening a surface using a chemical such as an acid or an alkali, or a method for forming a film having a rough surface by applying an ink which contains inorganic or organic particles beforehand to form a coating film having a rough surface (Fig. 4c). The thickness of this light-absorbing layer 12 varies depending on the blackened material and/or the conductivity; however, in order to obtain sufficient electromagnetic-wave shielding properties without degrading the conductivity, the thickness is preferably set to approximately 1 nm to 10 µm. In addition, in order to sufficiently prevent light scattering, the degree of roughness of the surface 12A is preferably set to approximately 0.1 to 20 µm in terms of surface roughness Rz.

Next, after the light-absorbing layer 12 is formed, and the mat treatment is performed, the surface of the copper foil 11 which is processed by the mat treatment is adhered to a transparent base film such as a PET (poly(ethylene terephthalate)) film 13 with a transparent adhesive 14 (Figs. 4d and 4e).

Pattern etching is performed for the laminated film thus formed to partly remove the copper foil 11 provided with the light-absorbing layer 12, so that a copper/PET laminate etched film 10 is obtained as the electromagnetic-wave shielding film (Fig. 4f).

As the electrical conductive foil forming the electromagnetic-wave shielding film, besides a copper foil, for example, a metal foil of stainless steel, aluminum, nickel, iron, brass, or an alloy thereof may be used; however, a copper, a stainless steel, and an aluminum foil are preferable.

The thickness of this metal foil is preferably about 1 to 200 µm.

As a method for performing pattern etching of the metal foil, although any method may be used which has been generally used, photo-etching using a resist is preferable. In this case, after a photoresist film is press-bonded to a metal foil, or a photoresist is applied thereto, pattern exposure is performed using a desired mask, followed by forming a resist pattern by a development treatment. Subsequently, part of the metal foil, which is not provided with the resist, may be removed by an etching solution such as a ferric chloride solution.

When a photoresist film is used, it is preferable since this photoresist film, the metal foil provided with the light-absorbing layer and processed by the mat treatment, an adhesive sheet of the transparent adhesive, and the base film can be integrally formed into a laminate of the base film/adhesive sheet/metal foil/photoresist film in a single step by lamination and pressure bonding.

By pattern etching, the degree of freedom of patterning is high, and the metal foil can be etched to form an optional line diameter, space, and hole shape; hence, no moiré phenomenon occurs, and as a result, an electromagnetic-wave shielding film having desired electromagnetic-wave shielding properties and light transmission properties can be easily formed.

In order to simultaneously ensure the electromagnetic-wave shielding properties and the light transmission properties, an area ratio (hereinafter referred to as an "opening rate") of an opening portion of a project surface of this metal foil is preferably set to 20% to 90%.

As the transparent base film to be adhered to the metal foil such as the copper foil 11, besides the PET film 13, there may be mentioned a resin film made, for example, of polyester, poly(butylene terephthalate), poly(methylmethacrylate) (PMMA), acrylic plate, polycarbonate (PC), polystyrene, triacetate film, poly(vinyl alcohol), poly(vinyl chloride), poly(vinylidene chloride), polyethylene, ethylene-vinyl acetate copolymer, poly(vinyl butyral), metal ion-crosslinked ethylene methacrylic acid copolymer, polyurethane, or cellophane, and among those mentioned above, PET, PBT (poly(butylene terephthalate)), PC, PMMA, and acrylic film are preferable. The thickness thereof is preferably set to approximately 1 to 200 µm since sufficient durability and handling properties are obtained without excessively increasing the thickness of a display panel to be formed.

As the transparent adhesive 14 which adheres the transparent base film to the metal foil, for example, an EVA or a PVD resin may be used, and methods and conditions for sheet formation and adhesion thereof may be similar to those mentioned above. An epoxy, acrylic, urethane, polyester, or rubber-based transparent adhesive may be used. A urethane or an epoxy-based adhesive is particularly preferable since it has superior etching resistance in an etching step performed after the lamination. The thickness of the adhesive layer by this transparent adhesive 14 is preferably 1 to 50 µm. This transparent adhesive 14 may contain electrical conductive particles, which will be described later, whenever necessary.

Hereinafter, individual constituent materials of the display panel 1 and the electromagnetic-wave shielding and light transmitting window material 31 will be described.

As the anti-reflection films 3 and 35, for example, a film may be mentioned which has the structure made of a base film 3A (having a thickness, for example, of approximately 25 to 250 µm) made of PET, PC, PMMA or the like and an anti-reflection layer 3B provided on the base film 3A, the anti-reflection layer 3B being a monolayer film having a low refractive index or a laminate film formed of a high refractive-index transparent film and a low refractive-index transparent film.

On the anti-reflection film, a contamination-resistant film may be further formed so as to enhance contamination-resistant properties of the surface. As this contamination-resistant film, a thin film made, for example, from a fluorine-based thin film or a silicone-based thin film having a thickness of approximately 1 to 100 nm is preferably used.

As the near infrared cut film 5, for example, a film may be used which is formed of a base film 5A and a coating layer or a multi-coating layer 5B provided thereon, the coating layer being formed of a copper-based inorganic material, a copper-based organic material, or a near-infrared absorbing material such as a cyanine-based, a phthalocyanine-based, a nickel complex-based, or a diimmonium-based material, the multilayer-coating layer 5B being composed of a metal such as silver and an inorganic dielectric material such as zinc oxide or ITO (indium tin oxide). As this base film 5A, a film made, for example, of PET, PC, or PMMA may be used. The thickness of this film is preferably in the range of approximately 10 µm to 1 mm. In addition, the thickness of the near infrared cut coating layer 5A formed on this base film 5A is generally in the range of approximately 0.5 to 50 µm.

As the adhesive resin forming the adhesive interlayer films 4A, 4B, 4C, 34A, and 34B, a cross-linking type thermosetting resin containing a cross-linking agent is preferable, and in particular, a cross-linking type EVA resin is preferable.

Hereinafter, the cross-linking type EVA resin used as this adhesive resin will be described in detail.

As this EVA, a material containing 5 to 50 percent by weight or preferably containing 15 to 40 percent by weight of vinyl acetate is used. When the content of vinyl acetate is less than 5 percent by weight, the weatherability and the transparency become problems. In addition, when the content is more than 40 percent by weight, beside serious degradation in mechanical properties, it becomes difficult to form its film, and blocking occurs between films.

As the cross-linking agent, an organic peroxide is preferably used and is selected in consideration of a sheet forming temperature, a cross-linking temperature, a shelf life, and the like. As a usable peroxide, for example, there may be mentioned 2,5-dimethylhexane-2,5-dihydroxyperoxide, 2,5-dimethyl-2,5-di(t-butylperoxy)hexane-3, di-t-butylperoxide, t-butylcumylperoxide, 2,5-dimethyl-2,5-di(t-butylperoxy)hexane, dicumylperoxide, α,α'-bis(t-butylperoxyisopropyl)benzene, n-butyl-4,4-bis(t-butylperoxy)valerate, 2,2-bis(t-butylperoxy)butane, 1,1-bis(t-butylperoxy)cyclohexane, 1,1-bis(t-butylperoxy)-3,3,5-trimethylcyclohexane, t-butyl-peroxybenzoate, benzoylperoxide, t-butylperoxyacetate, 2,5-dimethyl-2,5-di(t-butylperoxy)hexyne-3, 1,1-bis(t-butylperoxy)-3,3,5-trimethylcyclohexane, 1,1-bis(t-butylperoxy)cyclohexane, methyl ethyl ketone peroxide, 2,5 dimetylhexyl-2,5-bisperoxybenzoate, t-butylhydroperoxide, p-menthanehydro-peroxide, p-chlorobenzoylperoxide, t-butylperoxyisobutylate, hydroxyheptylperoxide, and chlorohexanoneperoxide. These peroxides may be used alone or in combination as a mixture containing at least two of them, and 10 parts by weight or less thereof is used to 100 parts by weight of EVA, or 0.1 to 10 parts by weight is preferably used.

An organic peroxide is generally compounded with EVA using an extruder, a roll mill, or the like; however, after being dissolved in an organic solvent, a plasticizer, a vinyl monomer, or the like, an organic peroxide may be added to an EVA film by an impregnation method.

In addition, in order to improve EVA properties (mechanical strength, optical properties, adhesion properties, weatherability, whitening resistance, cross-linking rate, and the like), various compounds containing an ally group and an acryloxy group or a methacryloxy group may be added. As compounds used for this purpose, acrylic acid or methacrylic acid derivatives, such as esters and amides thereof, are most commonly used, and as ester residues, besides alkyl groups such as methyl, ethyl, dodecyl, stearyl, and lauryl, for example, a cyclohexyl, tetrahydrofurfuryl, aminoethyl, 2-hydroxyethyl, 3-hydroxypropyl, and 3-chloro-2-hydroxypropyl group may be mentioned. In addition, an ester formed with a polyfunctional alcohol, such as ethylene glycol, triethylene glycol, polyethylene glycol, trimethylol propane, or pentaerythritol may also be used. As the amide, diacetone acrylamide is a representative compound.

In more particular, for example, there may be mentioned a polyfunctional ester such as an acrylic or a methacrylic ester of trimethylol propane, pentaerythritol, or glycerin; or an allyl group-containing compound, such as triallyl cyanurate, triallyl isocyanurate, diallyl phthalate, diallyl isophthalate, or diallyl maleate. These materials may be used alone or in combination as a mixture containing at least two thereof, and 0.1 to 2 parts by weight is generally used to 100 parts by weight of EVA, and preferably 0.5 to 5 parts by weight is used.

The thickness of the adhesive interlayer films 4A, 4B, 4C, 34A, and 34B is preferably in the range of approximately 10 to 1,000 µm.

In addition, in the adhesive interlayer films 4A, 4B, 4C, 34A, and 34b, a small amount of an ultraviolet absorber, an infrared absorber, an anti-aging agent, and/or a paint processing auxiliary agent may also be contained. In order to adjust the coloring of a filter itself, an appropriate amount of a coloring agent such as a dye or a pigment and a filler agent such as carbon black, hydrophobic silica, or calcium carbide may also be added.

As means for improving the adhesion, for example, means such as corona discharge treatment, low-temperature plasma treatment, electron beam irradiation, or ultraviolet irradiation may be effectively performed on a surface of a sheeted adhesive interlayer film.

This adhesive interlayer film is formed by mixing the adhesive resin with the afore-mentioned additives, compounding this mixture using an extruder, a roll mill or the like, and then molding this compound into a sheet having a predetermined shape by a film-forming method such as calendering, rolling, T-die extrusion, or inflation. In the film formation, embossing is performed so as to prevent blocking and to easily perform deaeration when pressure bonding is performed.

As the adhesive interlayer films 4A, 4B, 4C, 34A, and 34B, besides the above adhesives, a transparent adhesive (pressure-sensitive adhesive) may also be preferably used. As this transparent adhesive, a thermoplastic elastomer-based adhesive made, for example, of an acrylic, a SBS, or a SEBS-based material may be preferably used. To these transparent adhesives, a tackifier, an ultraviolet absorber, a coloring pigment, a coloring dye, an anti-aging agent, an adhesion promoter, and/or the like may be optionally added. The transparent adhesive may be provided beforehand on adhesive surfaces of the anti-reflection film 3, the electromagnetic-wave shielding films 10 and 10a, and the near infrared cut film 5 by coating or lamination to have a thickness of 5 to 100 µm, so that those films can be adhered to the PDP main body 20 and/or other films.

It is preferable that the near infrared cut film 5 be adhered using an adhesive to form a laminate. The reason for this is that the near infrared cut film 5 is weak against heat and cannot withstand a heating cross-linking temperature (130 to 150°C). When a low-temperature cross-linking type EVA (cross-linking temperature of approximately 70 to 130°C) is used as an adhesive, the adhesion of the near infrared cut film 5 can be performed.

As the electrical conductive adhesive tapes 7, 8, and 30, tapes may be used in which adhesive layers 7B, 8B, and 37B containing electrical conductive particles dispersed therein are provided on one-side surfaces of metal foils 7A, 8A, 37A, respectively, as shown in the figure, and as the adhesive layers 7B, 8B, and 37B, an acrylic-based, a rubber-based, or a silicone-based adhesive, or an epoxy-based or a phenol-based resin blended with a curing agent may be used.

As the electrical conductive particles dispersed in the adhesive layers 7B, 8B and 37B, any superior electrical conductor may be used, and hence various materials may be used. For example, powdered metal such as copper, silver, or nickel, or powdered resin or ceramic coated with the metal as mentioned above may be used. The shape of particles may be any one of scale, dendrite, grain, pellet or the like; however, the shape is not limited thereto.

The blending amount of the electrical conductive particles is preferably 0.1 to 15 percent by volume to a polymer forming the adhesive layers 7B, 8B, and 37B. The average particle diameter of the particles is preferably 0.1 to 100 µm. By this blending amount of electrical conductive particles having this particle diameter, aggregation thereof is prevented, and as a result, superior conductivity can be obtained.

The metal foils 7A, 8A, and 37A used as the base materials of the electrical conductive adhesive tapes 7, 8, and 37 may be formed of copper, silver, nickel, aluminum, stainless steel, and the like. The thickness of the foil is set to approximately 1 to 100 µm.

The adhesive layers 7B, 8B, and 37B can be easily formed by applying the above adhesive which is uniformly mixed with the electrical conductive particles at a predetermined ratio to the metal foils 7A, 8A, and 37A by a roll coater, a die coater, a knife coater, a micabar coater, a flow coater, a spray coater, or the like.

The thickness of the adhesive layers 7B, 8B, and 37B is preferably around 5 to 100 µm.

An example of a manufacturing method of an electromagnetic-wave shielding and light transmitting window material will be described below.

### [Manufacturing of Adhesive Interlayer Film]

An ethylene-vinyl acetate copolymer (Ultrathene 634 manufactured by Toyo Soda Manufacturing Co., Ltd: a vinylacetate content of 26%, a melt index of 4) in an amount of 100 parts by weight, 1 part by weight of 1,1-bis(t-butylperoxy)-3,3,5-trimethylcyclohexane (Perhexa 3M manufactured by NOF Corporation), 0.1 parts by weight of γ-methacryloxypropyltrimethoxysilane, 2 parts by weight of dially phthalate, and 0.5 parts by weight of Sumisorb 130 (manufactured by Sumitomo Chemical Co., Ltd) as an ultraviolet absorber were mixed together, followed by extrusion by a 40-mm extruder, so that an adhesive resin film having two embossed surfaces was formed.

### Example 1

By using 2 glass plates having a thickness of 2.0 mm as a front surface-side transparent substrate, after high-frequency heating electrodes were extended from an electromagnetic-wave shielding etched mesh film, this film was laminated by two adhesive resin films located at a top and a bottom side. Subsequently, after the laminate thus formed was sandwiched by two silicone rubber sheets, and vacuum deaeration was performed, heating was performed at a temperature of 90°C for 10 minutes, so that pre-pressure bonding was performed. Then, after pressing was performed using pressing plates, a high frequency of 13.56 MHz was applied to the pressing plates or the electrodes extended from the etched film to perform high-frequency heating, and in addition, heating was also performed by heaters provided for the pressing plates, so that cross linking of adhesive interlayer films was performed at 130°C for a predetermined time.
After the heating, a peeling test was performed, and it was determined that the cross-linking was complete when a predetermined adhesion strength was obtained. In addition, the time required therefor was regarded as a cross-linking time.
In the case in which high frequency was not applied, the cross-linking time was 40 minutes; however, when high frequency was applied to the pressing plates, it was 25 minutes, and when high frequency was applied to the etched film, the cross-linking time was significantly decreased to 20 minutes.

Hereinafter, an embodiment of a manufacturing method of a solar battery module according to the third aspect will be described in detail.

Fig. 5 is a schematic cross-sectional view of a sealing step of solar battery cells according to the third aspect.

The method according to the third aspect can be performed in a manner similar to that of the above method shown in Fig. 6 except that induction heating is used as heating means as shown in Fig. 5.

That is, between top and bottom pressing plates 51 and 52 made of a dielectric material such as a metal, a top mold 53 and a bottom mold 54, which are made of a synthetic resin having high heat resistance, are disposed, and between the molds 53 and 54, a laminate shown in Fig. 6 is disposed.

This laminate has the structure in which the solar battery cells 64 are disposed between the front surface-side transparent protective member 61 located at a light-receiving surface side and the rear surface-side protective member (back cover member) 62 with the sealing films 63A and 63B which are interposed therebetween and are made of ethylene-vinyl acetate copolymer (EVA) resin films.

While air in the molding space between the molds 53 and 54 is vacuum-evacuated via an exhaust port 55, a high-frequency voltage is simultaneously applied to the pressing plates 51 and 52 from a high-frequency power source 56, and the laminate described above is pressed by the pressing plates 51 and 52 for a predetermined time. The sealing films 63A and 63B of EVA are heated by induction heating and are cured, so that the laminate is integrated.

Subsequently, the application of the high-frequency voltage is stopped, the pressing plates 51 and 52 and the molds 53 and 54 are respectively separated, and the solar cell module is then recovered from the molds.

Since the sealing films are rapidly heated by this high-frequency induction heating, the cycle time of this sealing step can be decreased as compared to that in the past, and as a result, the manufacturing efficiency can be improved.

According to the description with reference to Fig. 5, high-frequency heating is performed; however, microwave heating may be performed instead. In general, the high-frequency heating and the microwave heating are frequently performed in the range of 1 MHz to 100 MHz and 300 MHz to 300 GHz, respectively; however, in the third aspect, high-frequency heating or microwave heating is preferably performed in the range of approximately 3 KHz to 30 GHz. When heating of the laminate is performed using a conventional temperature-constant bath, approximately 1 to 10 minutes is required as the cycle time; however, according to the third aspect, even within less than 1 minute, a solar battery module can be obtained in which the adhesion is sufficiently performed.

In Fig. 5, the heating is performed only by induction heating; however, by providing heat sources such as an electrical heater for the pressing plates 51 and 52, the heating of the laminate may be assisted by heat transfer from the pressing plates 51 and 52. That is, the induction heating and the heat-transfer heating may both be used. When the heating is performed as described above, the cycle time of the sealing step can be further decreased, and in addition, the entire laminate can be more uniformly heated.

In Fig. 5, the pressing plates 51 and 52 are used as electrodes for the induction heating; however, the electrodes may be provided on surfaces of the pressing plates facing to each other. The conduction portion (such as the silicon substrate) of the cell 64 may be used as the electrode for induction heating.

Next, individual constituent members of the solar battery module will be described.

The back cover member is preferably formed by integrally laminating two heat-resistant and weather-resistant films with a moisture-proof film interposed therebetween. In this back cover member, the sealing film 14 may also be integrated.

As the moisture-proof layer preventing moisture from entering the solar battery module via the rear surface thereof, a film is used having a base film and a deposition film provided thereon which is primarily formed of an inorganic oxide such as silicon oxide by a CVD (chemical vapor deposition) method, a PVD (reaction deposition) method, or the like.

As the inorganic oxide forming the deposition film, that is, the inorganic oxide as a moisture-proof layer, for example, aluminum oxide or silicon oxide may be used; however, since having superior durability under high temperature and high humidity conditions, in particular, silicon oxide is preferable.

The composition of the silicon oxide deposition film is represented by SiOₓ. When x of SiOₓ is less than 1.7, the moisture permeability gradually decreases in a durability test or the like, and when x is more than 1.9, it is disadvantageous in view of productivity and cost. Hence, the SiOₓ composition of a silicon oxide deposition film used as the moisture-proof layer is preferable so that x = 1.7 to 1.9 holds.

When the thickness of the deposition film is excessively small, sufficient moisture-proof properties cannot be obtained. When the thickness is excessively large, an effect of improving the moisture-proof properties cannot be further improved, and unfavorably, cracking is liable to occur, so that the moisture-proof properties may be degraded in some cases. Hence, the thickness of the film is set to 100 to 500 Å and is particularly preferably set to 200 to 400 Å.

As the base film used as a support member of the moisture-proof film, any heat resistant film may be used as long as it can withstand heat and pressure conditions when the solar battery module is formed, and hence the base film is not particularly limited. However, in general, for example, there may be used fluorinated resin films such as polytetrafluoroethylene (PTFE), 4-fluoroethylene-perfluoroalkoxy-copolymer (PFA), 4-fluoroethylene-6-fluoropropylene-copolymer (FEP), 2-ethylene-4-fluoroethylene-copolymer (ETFE), poly(3-fluorochloroethylene) (PCTFE), polyvinylidene fluoride (PVDF), and polyvinyl fluoride (PVF); and various resin films of polyester resins such as poly(ethylene terephthalate) (PET), polycarbonate, poly(methylmethacrylate) (PMMA), polyamide, and the like. The base film may include at least two types of resins mentioned above or may be a multi-layer film formed of at least two of the above resin films. Whenever necessary, various additives such as a pigment and an ultraviolet absorber may be added to the base film by impregnation, coating, or kneading.

The heat-resistant and weather-resistant films forming the back cover member 62 by integral lamination with the moisture-proof film interposed therebetween are provided, for example, in order to protect the moisture-proof film and to improve workability during solar battery module formation. As the weather-resistant film which is used as the outermost layer when the solar battery module is assembled, a film is desired which is not degraded for a long period of time under outdoor exposure condition, and in general, the materials of the base films mentioned above by way of example may also be used. This heat-resistant and weather-resistant film may include at least two types of resins mentioned above or may be a laminate film including at least above two films as is the base film of the moisture-proof film. To the heat-resistant and weather-resistant film, whenever necessary, various additives such as a pigment, an ultraviolet absorber, and/or a coupling agent may be added by impregnation, coating, or kneading.

The color of the back cover member 62 is not particularly limited; however, in order to improve the power generation efficiency, a white-based color is preferable, and for improvement in appearance when the solar battery modules are installed in houses, black color or various deep colors are used.

As the front surface side protective member 61, for example, a glass plate having a thickness of approximately 1 to 5 mm or a high-performance laminate film having a thickness of approximately 10 to 200 µm may be used.

As the sealing films 63A and 63B, an EVA-based resin film is particularly preferable, and in particular, a resin containing 5 to 50 percent by weight of vinyl acetate is used, and a resin containing 15 to 40 percent by weight is preferably used. When the content of vinyl acetate is less than 5 percent by weight, the weatherability and the transparency become problems. On the other hand, when the content is more than 40 percent by weight, beside serious degradation in mechanical properties, it becomes difficult to form a film, and blocking occurs between sheets or films.

In the EVA resin composition used for sealing purpose, a cross-linking structure is preferably formed by addition of a cross-linking agent in order to improve the weatherability. As this cross-linking agent, in general, an organic peroxide is used which generates radicals at 100°C or more, and in particular, in consideration of the stability in blending, a peroxide having a decomposition temperature of 70°C or more at a half-life period of 10 hours is preferably used. As the peroxide, for example, there may be mentioned 2,5-dimethylhexane, 2,5-dihydroxyperoxide, 2,5-dimethyl-2,5-di(t-butylperoxy)hexane, 3-di-t-butylperoxide, t-dicumylperoxide, 2,5-dimethyl-2,5-di(t-butylperoxy)-hexyne, dicumylperoxide, α, α'-bis(t-butylperoxyisopropyl)benzene, n-butyl-4,4-bis(t-butylperoxy)butane, 2,2-bis(t-butylperoxy)butane, 1,1-bis(t-butylperoxy)cyclohexane, 1,1-bis(t-butylperoxy)-3,3,5-trimethylcyclohexane, t-butylperoxybenzoate, or benzoyl peroxide. The blending amount of the organic peroxide is generally 5 parts by weight or less to 100 parts by weight of the EVA resin and is preferably 1 to 3 parts by weight.

In order to enhance the adhesion, a silane coupling agent may be added to the EVA resin. As known silane coupling agents used for this purpose, for example, there may be mentioned γ-chloropropyltrimethoxysilane, vinyltrichlorosilane, vinyltriethoxysilane, vinyl-tris-(β-methoxyethoxy) silane, γ-methacryloxypropyltrimethoxysilane, β-(3,4-ethoxycyclohexyl)ethyltrimethoxysilane, γ-glycidoxypropyltrimethoxysilane, vinyltriacetoxysilane, γ-mercaptopropyltrimethoxysilane, γ-aminopropyltrimethoxysilane, and N-β-(aminoethyl)-γ-aminopropyltrimethoxysilane. The blending amount of the silane coupling agent is generally 5 parts by weight or less to 100 parts by weight of the EVA resin and is preferably 0.1 to 2 parts by weight.

In order to improve the gel fraction and to improve the durability of the EVA resin, a cross-linking auxiliary agent may be added thereto. As the cross-linking auxiliary agent used for this purpose, for example, besides trifunctional cross-linking agents such as triallyl cyanurate and trially isocyanate, monofunctional cross-linking auxiliary agents such as NK ester may be mentioned as a known agent. The blending amount of the cross-linking auxiliary agent is 10 parts by weight or less to 100 parts by weight of the EVA resin and is preferably 1 to 5 parts by weight.

In order to improve the stability of the EVA resin, for example, hydroquinone, hydroquinone monomethyl ether, p-benzoquinone, and/or methyl hydroquinone may be added. The blending amount thereof is generally 5 parts by weight or less to 100 parts by weight of the EVA resin.

Whenever necessary, in addition to the afore-mentioned additives, for example, a coloring agent, an ultraviolet absorber, an anti-aging agent, and/or an anti-discoloration agent may be added. As the coloring agent, for example, there may be mentioned an inorganic pigment such as a metal oxide or a metal powder, or an organic pigment such as a lake pigment of an azo, a phthalocyanine, an azi, an acid dye, or a basic dye group. As the ultraviolet absorber, for example, there may be mentioned a benzophenone-based compound such as 2-hydroxy-4-octoxybenzophenone or 2-hydroxy-4-methoxy-5-sulfobenzophenone; a benzotriazole-based compound such as 2-(2'-hydroxy-5-methylphenyl)-benzotriazole; or a hindered amine-based compound such as phenylsulcylate or p-t-butylphenylsulcylate. As the anti-aging agent, for example, an amine-based, a phenol-based, a bisphenyl-based, or a hindered amine-based compound may be mentioned. Among those, for example, di-t-butyl-p-cresol or bis(2,2,6,6-tetramethyl-4-piperadyl)sebacate may be mentioned.

Subsequently, an example of a manufacturing method of a solar battery module will be described.

### Example 2

After each film was formed from an EVA resin composition containing the following components, embossing was performed, so that a transparent EVA film was manufactured.

### [Components of EVA Resin Composition for Transparent EVA Film (Parts by Weight)]

EVA resin: 100
Cross-linking agent (1,1-bis(t-butylperoxy)-3,3,5-trimethylcyclohexane): 2.0
Silane coupling agent (γ-methacryloxypropyltrimethoxysilane): 0.5
Anti-yellowing agent: 0.1
Cross-linking auxiliary agent (triallyl isocyanurate): 2.0
Ultraviolet absorber (2-hydroxy-4-octylbenzophenone): 0.03

The transparent EVA films thus formed were used as a rear surface side sealing film and a front surface-side sealing film, and solar battery cells (silicon power generation elements) were sealed between a glass plate having a thickness of 3 mm and a back cover 2 made of a fluorinated polyethylene film having a thickness of 38 µm, so that the solar battery was formed. After electrodes for high-frequency application were extended beforehand from the solar battery cells, the solar battery cells were sandwiched by 2 silicone rubber sheets, and vacuum evacuation was then performed, followed by pre-pressure bonding at a temperature of 150°C for 5 minutes. Subsequently, after applying a pressure using pressing plates, a high frequency of 13.65 MHz was applied to the pressing plates or the electrodes extended from the etched film for high-frequency heating, and at the same time, heating was performed by the pressing plates using heaters, so that adhesive interlayer films were cross-linked at 150°C for a predetermined time.
After the heating, a peeling test was carried out, and when a predetermined strength was obtained, it was determined that the cross-linking was complete, and the time required for that was regarded as a cross-linking time.
Although the cross-linking time was 45 minutes when the high frequency was not applied, when the high frequency was applied to the pressing plates, the cross-linking time was 30 minutes, and when high frequency was applied to the electrical conductive portions of the cells, the cross-linking time could be significantly decreased to 25 minutes.

## Claims

1. A method for manufacturing an electromagnetic wave shielding and light transmitting window material in which a transparent base material and an electrical conductive layer adhered to each other with an adhesive resin interposed therebetween, the method comprising the step of:
heating a laminate of the transparent base material, the electrical conductive layer, and the adhesive resin for adhesion,
wherein the heating is performed by induction heating.

2. The method for manufacturing an electromagnetic wave shielding and light transmitting window material, according to Claim 1, wherein the induction heating is performed together with heat-transfer heating using a heat source.

3. The method for manufacturing an electromagnetic wave shielding and light transmitting window material, according to Claim 1 or 2, wherein the induction heating is high-frequency induction heating.

4. The method for manufacturing an electromagnetic wave shielding and light transmitting window material, according to Claim 1, wherein the induction heating is microwave induction heating.

5. The method for manufacturing an electromagnetic wave shielding and light transmitting window material, according to Claim 1, wherein the electrical conductive layer is an electrical conductive mesh, and
the electromagnetic wave shielding and light transmitting window material is formed of the electrical conductive mesh provided between two transparent substrates, a peripheral portion of the electrical conductive mesh is extended past peripheral portions of the transparent substrates and is folded along the peripheral portions of the transparent substrates.

6. The method for manufacturing an electromagnetic wave shielding and light transmitting window material, according to Claim 1, wherein the electrical conductive layer is an electrical conductive mesh and is used as an electrode applying a high frequency during induction heating.

7. A method for manufacturing a display panel which has a display panel main body and an electromagnetic wave shielding film adhered to a front surface of the display panel main body with an adhesive resin interposed therebetween, the method comprising the step of:
heating a laminate of the display panel main body and the electromagnetic wave shielding film for adhesion,
wherein the heating is performed by induction heating.

8. The method for manufacturing a display panel, according to Claim 7, wherein the induction heating is performed together with heat-transfer heating using a heat source.

9. The method for manufacturing a display panel, according to Claim 7, wherein the induction heating is high-frequency induction heating.

10. The method for manufacturing a display panel, according to Claim 7, wherein the induction heating is microwave induction heating.

11. The method for manufacturing a display panel, according to Claim 7, wherein the electromagnetic wave shielding film has a transparent base film and a pattern-etched electrical conductive foil adhered to the base film with a transparent adhesive.

12. The method for manufacturing a display panel, according to Claim 7, wherein the display panel main body is a plasma display.

13. A method for manufacturing a solar battery module in which at least one solar battery cell is sealed between a front surface side protective member and a rear surface side protective member, the method comprising the steps of:
disposing the solar battery cell between the front surface side protective member and the rear surface side protective member with at least one sealing film which is interposed therebetween and which is made of an adhesive resin so as to form a laminate; and heating this laminate under reduced pressure or increased pressure,
wherein induction heating is performed in the heating step.

14. The method for manufacturing a solar battery module, according to Claim 13, wherein the induction heating is performed together with heat-transfer heating using a heat source.

15. The method for manufacturing a solar battery module, according to Claim 13, wherein the induction heating is high-frequency induction heating.

16. The method for manufacturing a solar battery module, according to Claim 13, wherein the induction heating is microwave induction heating.

17. The method for manufacturing a solar battery module, according to Claim 13, wherein an electrical conductive portion of the cell is used as an electrode for induction heating.

18. The method for manufacturing a solar battery module, according to Claim 13, wherein the adhesive resin is an ethylene-vinyl acetate copolymer resin.
